# FASCICULE DE BREVET EUROPEEN

(11) **EP 3 639 636 B1**
(45) Date de publication et mention de la délivrance du brevet: **18.05.2022**
(21) Numéro de dépôt: 18729632.2
(22) Date de dépôt: 01.06.2018
(51) Int. Cl.: H05K 7/20

(54) **DISPOSITIF DE REFROIDISSEMENT DE BAIES AVIONIQUES A LIQUIDE CALOPORTEUR**
VORRICHTUNG ZUR KÜHLUNG VON AVIONIK-RACKS MIT EINEM WÄRMEÜBERTRAGUNGSFLUID
DEVICE FOR COOLING AVIONICS RACKS WITH A HEAT-TRANSFER FLUID

(30) Priorité: 12.06.2017 FR 1755242
(43) Date de publication de la demande: 22.04.2020
(73) Titulaire: Safran Electronics & Defense, 75015 Paris (FR); Safran Electrical & Power, 31702 Blagnac Cedex (FR)
(72) Inventeur: GUILLOT, François, 77550 Moissy-Cramayel (FR); BLINEAU, Jean-Marc, 31702 Blagnac cedex (FR); AVIGNON, Philippe, 31702 Blagnac cedex (FR); ROQUES, Serge, 31702 Blagnac cedex (FR); ALBERO, Franck, 31702 Blagnac cedex (FR)
(74) Mandataire: Lavialle, Bruno François Stéphane
(86) Numéro de dépôt international: PCT/EP2018/064528
(87) Numéro de publication internationale: WO 2018/228834

(56) Documents cités:
- US-A1- 2005 160 752

## Description

### DOMAINE DE L'INVENTION

L'invention s'applique au domaine des baies avioniques destinées à recevoir des modules électroniques et plus particulièrement aux dispositifs de refroidissement de telles baies.

### ARRIERE PLAN DE L'INVENTION

Dans un aéronef, la gestion des commandes de vol et de l'ensemble des informations nécessaires au bon fonctionnement de l'aéronef est effectuée par des modules électroniques enfichés dans une ou plusieurs baies avioniques réparties dans l'aéronef. Lors de leur fonctionnement, les modules électroniques génèrent de la chaleur qu'il faut évacuer afin de ne pas compromettre l'intégrité des modules et/ou leurs performances. Cette évacuation se fait, classiquement, à l'aide d'un dispositif de refroidissement d'un module électronique placé dans une baie d'aéronef qui comprend des moyens de forçage d'un flux d'air de ventilation dans la baie avionique. Ce flux d'air est prélevé et retourné dans un circuit de ventilation qui parcourt l'aéronef. La miniaturisation des composants et donc leur concentration dans les modules électroniques augmente la quantité de chaleur à évacuer. Il est alors nécessaire d'augmenter également le volume d'air de ventilation traversant la baie. Il a été envisagé d'augmenter les débits d'air circulant dans le circuit de ventilation, mais une telle solution s'avère bruyante et requiert d'augmenter également les diamètres des conduits de ventilation. Le routage des conduits de ventilation augmente alors en complexité, et donc en coût et le poids des conduits augmente en conséquence. Un dispositif de refroidissement d'au moins un module électronique est connu de US 2005/160752 A1.

### OBJET DE L'INVENTION

L'invention a pour objet de réduire l'encombrement d'un dispositif de refroidissement d'un module électronique placé dans une baie d'aéronef.

### RESUME DE L'INVENTION

A cet effet, on prévoit un dispositif de refroidissement d'au moins un module électronique placé dans une baie avionique d'un aéronef comprenant une cabine ventilée. Le dispositif de refroidissement comprend un circuit fermé de circulation d'un liquide caloporteur, des premiers moyens de circulation du liquide caloporteur dans le circuit fermé, et un premier échangeur thermique comprenant un circuit froid qui est pourvu de premiers moyens de liaison au circuit fermé de liquide caloporteur et qui est thermiquement relié à une source chaude de la baie d'aéronef. Selon l'invention, le dispositif comprend un deuxième échangeur thermique comprenant un circuit chaud pourvu de deuxièmes moyens de liaison au circuit fermé de liquide caloporteur et un circuit froid thermiquement relié à une évacuation d'air de la cabine ventilée.

On exploite alors une ressource antérieurement perdue comme source froide à savoir le flux d'air en sortie de l'évacuation d'air de la cabine ventilée.

La fiabilité du dispositif de refroidissement est améliorée lorsque le premier échangeur thermique comprend des premiers moyens de forçage d'un flux d'air et/ou que le deuxième échangeur thermique comprend des deuxièmes moyens de forçage d'un flux d'air.

On obtient un dispositif particulièrement robuste et économique lorsque les premiers moyens et/ou les deuxièmes moyens de forçage d'un flux d'air comprennent un ventilateur.

On améliore encore la fiabilité du dispositif de refroidissement lorsque le premier échangeur thermique comprend des deuxièmes moyens de circulation du liquide caloporteur dans le circuit fermé.

Avantageusement le dispositif de refroidissement comprend des moyens de pilotage et d'alimentation des premiers moyens de forçage d'un flux d'air, ce qui permet de ne mettre en fonctionnement ces derniers que lorsque c'est nécessaire, réduisant alors la consommation électrique du dispositif de refroidissement.

Avantageusement encore, les premiers moyens de circulation du liquide caloporteur comprennent une turbine dont le rotor fait office d'induit en court-circuit. Cette conception est avantageuse du fait de sa simplicité de construction, d'utilisation et d'entretien, ainsi que de sa robustesse et de son faible coût de fabrication. En cas de défaillance de la turbine, la circulation de liquide n'est pas bloquée ce qui améliore encore la fiabilité du dispositif de refroidissement.

L'invention porte également sur un procédé de refroidissement d'un module électronique d'une baie d'aéronef selon revendication 8.

Enfin, l'invention porte également sur un aéronef comportant un dispositif de refroidissement précédemment décrit et/ou une baie avionique d'un type décrit ci-dessus.

D'autres caractéristiques et avantages ressortiront de la description qui suit d'un mode de réalisation non limitatif de l'invention.

### BREVE DESCRIPTION DES DESSINS

Il sera fait référence aux figures annexées parmi lesquelles :
- la figure 1 est une vue schématique en plan d'un aéronef comprenant un dispositif de refroidissement selon l'invention ;
- la figure 2 est une vue schématique en perspective d'une première baie avionique selon l'invention ;
- la figure 3 est une vue schématique en perspective d'une deuxième baie avionique selon l'invention ;
- la figure 4 est une vue schématique en coupe selon un plan IV-IV de la turbine du dispositif de la figure 1 ;
- la figure 5 est une vue schématique en coupe selon un plan V-V de la turbine de la figure 4.

### DESCRIPTION DETAILLEE DE L'INVENTION

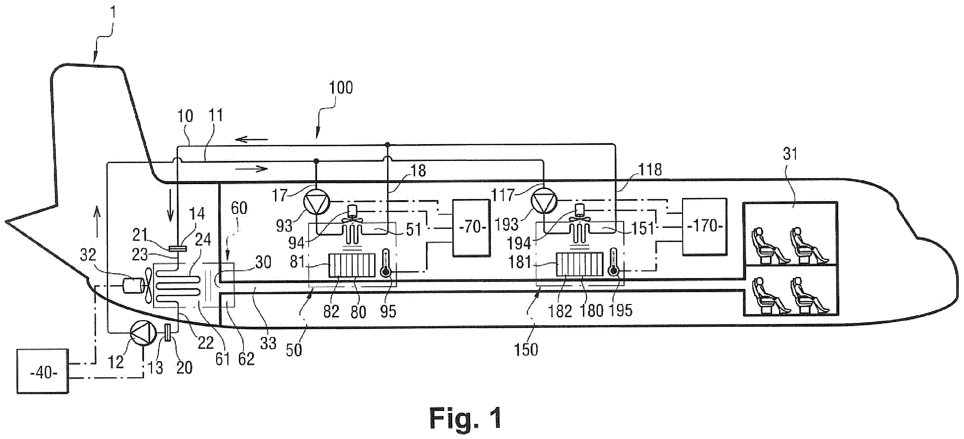

En référence à la figure 1, le dispositif de refroidissement de l'invention, généralement désigné 100, est destiné à refroidir une première baie avionique 80 d'un aéronef 1 dans laquelle sont enfichés deux modules électroniques 81 et 82 et une deuxième baie avionique 180 -identique à la première baie avionique 80- dans laquelle sont enfichés deux modules électroniques 181 et 182.

Le dispositif de refroidissement 100 comprend un circuit fermé 10 de circulation d'eau glycolée 11 réalisé en tube d'aluminium et une pompe de circulation 12. Le circuit fermé 10 comprend une première bride plate 13 et une deuxième bride plate 14 respectivement raccordées à des brides homologues 20 et 21 d'une entrée 22 et une sortie 23 d'un premier serpentin 24 en aluminium. Le premier serpentin 24 est placé en regard d'une évacuation d'air 30 d'une cabine 31 climatisée destinée à accueillir des passagers. Un premier ventilateur 32 relié à une unité de commande 40 est agencé pour forcer un flux d'air sur le premier serpentin 24.

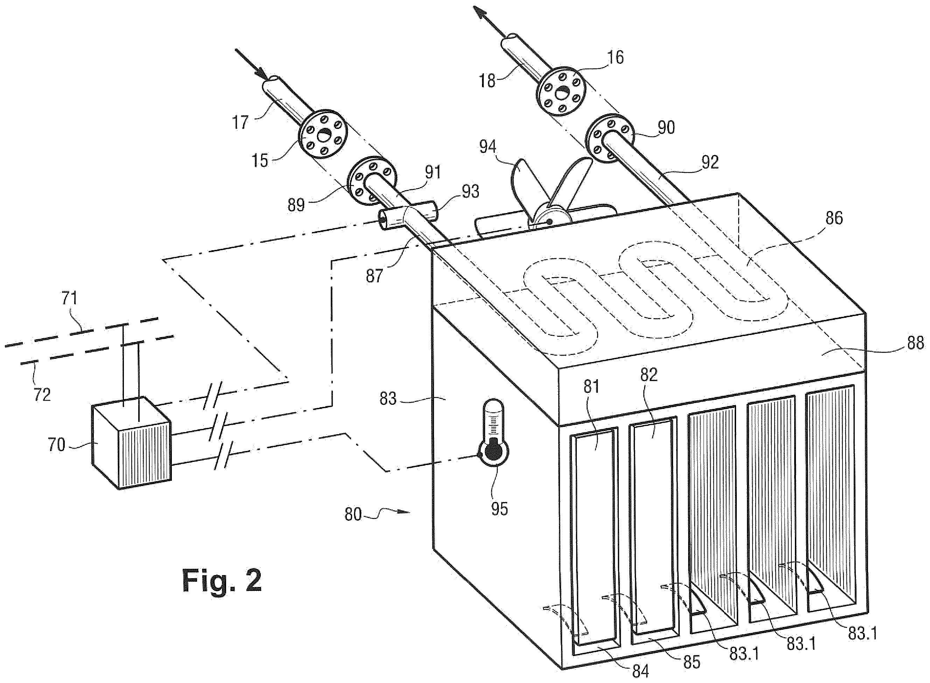

En référence à la figure 2, la première baie avionique 80 comprend un premier bâti 83 parallélépipédique en aluminium définissant des premières cellules 84 et 85 de réception des premiers modules électroniques 81 et 82. La première baie avionique 80 comprend une première unité d'alimentation et de communication 70 qui relie les premiers modules électroniques 81 et 82 aux réseaux d'alimentation électrique 71 et de communication/contrôle 72 de l'aéronef 1. Les premiers modules électroniques 81 et 82 sont maintenus en place dans les premières cellules 84 et 85 à l'aide de premières lames ressorts 83.1 en bronze solidaires du premier bâti 83. Un deuxième serpentin 86 réalisé à partir d'un tube 87 cintré en aluminium est soudé sur une première plaque 88 de fermeture de la partie supérieure du premier bâti 83. La première plaque 88 est également reliée par soudage au premier bâti 83. Le deuxième serpentin 86 comprend une troisième et une quatrième bride plate 89 et 90 respectivement placées sur une première conduite d'entrée 91 et une première conduite de sortie 92 du deuxième serpentin 86. Les troisième et quatrième brides plates 89 et 90 sont respectivement raccordées à des première et deuxième brides homologues 15 et 16 de liaison au circuit fermé 10. La première bride 15 est solidaire d'un premier piquage 17 d'arrivée d'eau glycolée 11 du circuit fermé 10 et la deuxième bride 16 est solidaire d'un deuxième piquage 18 de retour d'eau glycolée 11 vers le circuit fermé 10. La première conduite d'entrée 91 comprend un premier circulateur 93 à rotor noyé relié à la première unité d'alimentation et de communication 70. Un deuxième ventilateur 94 également relié à la première unité d'alimentation et de communication 70 est agencé pour forcer un flux d'air sur le deuxième serpentin 86. La première baie avionique 80 comprend également un premier capteur de température interne 95 résistif relié à la première unité d'alimentation et de communication 70.

Le deuxième serpentin 86 réalise, avec le premier bâti 83 de la première baie avionique 80, un premier échangeur thermique 50 dont le circuit froid 51, constitué du deuxième serpentin 86, est relié au circuit fermé 10. Le deuxième serpentin 86 est thermiquement relié au premier bâti 83 qui constitue une source chaude 52 du premier échangeur thermique 50, et échange, essentiellement par conduction, des calories avec les premiers modules électroniques 81 et 82. Ainsi l'eau glycolée 11 entrant à une température d'entrée T₉₁ dans la première conduite d'entrée 91 du deuxième serpentin 86 refroidit le premier bâti 83 par conduction, et ressort du deuxième serpentin 86 par la première conduite de sortie 92 à une température de sortie T₉₂ supérieure à la température d'entrée T₉₁.

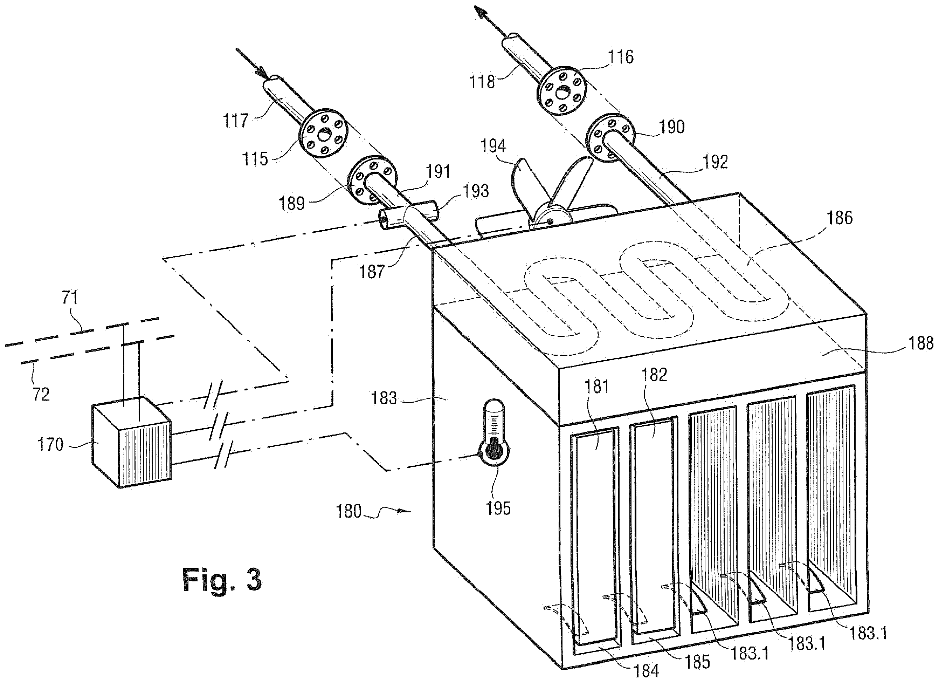

De manière homologue, et en référence à la figure 3, la deuxième baie avionique 180 comprend un deuxième bâti 183 parallélépipédique en aluminium définissant des deuxièmes cellules 184 et 185 de réception des deuxièmes modules électroniques 181 et 182. La deuxième baie avionique 180 comprend une deuxième unité d'alimentation et de communication 170 qui relie les deuxièmes modules électroniques 181 et 182 aux réseaux d'alimentation électrique 71 et de communication/contrôle 72 de l'aéronef 1. Les deuxièmes modules électroniques 181 et 182 sont maintenus en place dans les deuxièmes cellules 184 et 185 à l'aide de deuxièmes lames ressorts 183.1 en bronze solidaires du deuxième bâti 183. Un troisième serpentin 186 réalisé à partir d'un tube 187 cintré en aluminium est soudé sur une deuxième plaque 188 de fermeture de la partie supérieure du deuxième bâti 183. La deuxième plaque 188 est également reliée par soudage au deuxième bâti 183. Le troisième serpentin 186 comprend une cinquième et une sixième bride plate 189 et 190 respectivement placées sur une deuxième conduite d'entrée 191 et une deuxième conduite de sortie 92 du troisième serpentin 186. Les cinquième et sixième brides plates 189 et 190 sont respectivement raccordées à des troisième et quatrième brides homologues 115 et 116 de liaison au circuit fermé 10. La troisième bride 115 est solidaire d'un troisième piquage 117 d'arrivée d'eau glycolée 11 du circuit fermé 10 et la quatrième bride 116 est solidaire d'un quatrième piquage 118 de retour d'eau glycolée 11 vers le circuit fermé 10. La deuxième conduite d'entrée 191 comprend un deuxième circulateur 193 à rotor noyé relié à la deuxième unité d'alimentation et de communication 170. Un troisième ventilateur 194 également relié à la deuxième unité d'alimentation et de communication 170 est agencé pour forcer un flux d'air sur le troisième serpentin 186. La deuxième baie avionique 180 comprend également un deuxième capteur de température interne 195 résistif relié à la deuxième unité d'alimentation et de communication 170.

Le troisième serpentin 186 réalise, avec le deuxième bâti 183 de la deuxième baie avionique 180, un deuxième échangeur thermique 150 dont le circuit froid 151, constitué du troisième serpentin 186, est relié au circuit fermé 10. Le troisième serpentin 186 est thermiquement relié au deuxième bâti 183 qui constitue une source chaude 152 du deuxième échangeur thermique 150, et échange, essentiellement par conduction, des calories avec les deuxièmes modules électroniques 181 et 182. Ainsi l'eau glycolée 11 entrant à une température d'entrée T₁₉₁ dans la deuxième conduite d'entrée 191 du troisième serpentin 186 refroidit le deuxième bâti 183 par conduction, et ressort du troisième serpentin 186 par la deuxième conduite de sortie 192 à une température de sortie T₁₉₂ supérieure à la température d'entrée T₁₉₁.

Le premier serpentin 24 réalise, avec l'évacuation d'air 30 de la cabine 31, un troisième échangeur thermique 60 dont le circuit chaud 61, constitué du premier serpentin 24, est relié au circuit fermé 10. Le premier serpentin 24 est thermiquement relié à l'évacuation d'air 30, qui constitue une source froide 62 du troisième échangeur thermique 60, et échange, par conduction, des calories avec l'évacuation d'air 30. Ainsi, l'eau glycolée 11 entrant à une température d'entrée T₂₂ dans le premier serpentin 24 se refroidit par échange convectif avec un flux d'air 33 issu de l'évacuation d'air 30 et ressort du premier serpentin 24 à une température de sortie T₂₃ inférieure à la température d'entrée T₂₂.

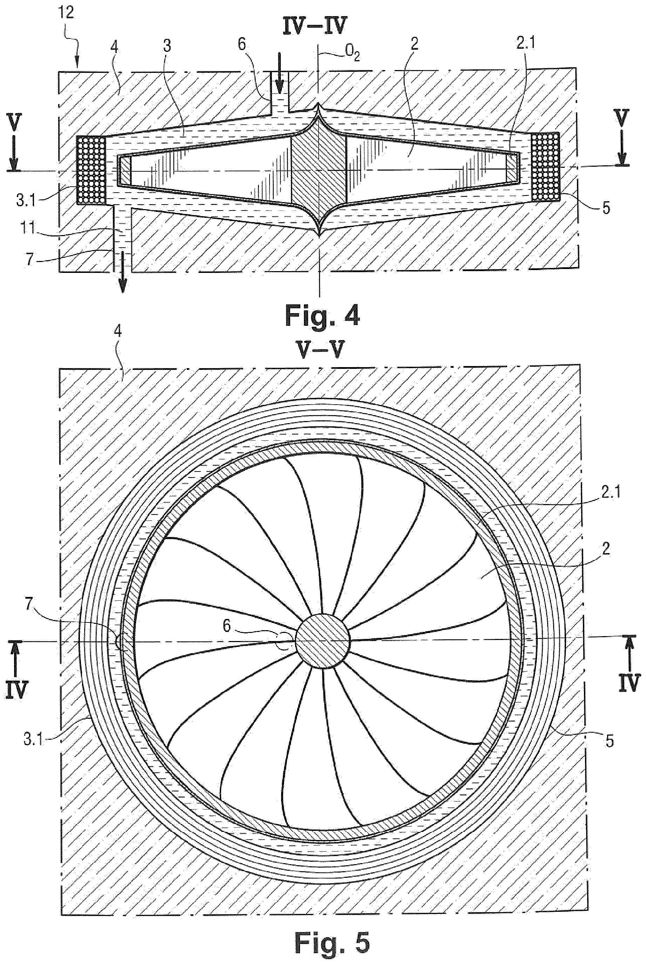

En référence aux figures 4 et 5, la pompe de circulation 12 comprend une turbine 2 métallique montée à rotation dans un logement 3 cylindrique du bâti 4 de la pompe de circulation 12. La périphérie 3.1 du logement 3 comprend des enroulements statoriques 5 qui ceinturent à distance le bord extérieur 2.1 de la turbine 2. Une entrée 6 et une sortie 7 d'eau glycolée 11 ménagées dans le bâti 4 débouchent dans le logement 3. L'entrée 6 débouche à proximité de l'axe de rotation O₂ de la turbine 2 et la sortie 7 débouche à proximité du bord extérieur 2.1 de la turbine 2. La turbine 2 est entrainée en rotation à l'aide de champs magnétiques tournants générés par les enroulements statoriques 5 comme pour une machine asynchrone triphasée. La turbine 2 constitue le rotor de la machine asynchrone et fait office d'induit en court-circuit.

En fonctionnement, l'unité de commande 40 commande la mise en route de la pompe de circulation 12. Les première et deuxième unités d'alimentation et de communication 70 et 170 maintiennent respectivement les premier et deuxième circulateur 93 et 193 ainsi que les deuxièmes ventilateurs 94 et 194 hors tension et surveillent les températures de l'intérieur des première et deuxième baies avioniques 80 et 180 à l'aide des premier et deuxième capteurs de température 95 et 195. La chaleur générée par les premiers modules 81 et 82 lors de leur fonctionnement est transmise au premier bâti 83 selon les modes suivants :
- rayonnement depuis les premiers modules 81 et 82 vers le premier bâti 83 et notamment la première plaque 88;
- convection depuis les premiers modules 81 et 82 et l'air contenu dans la première baie 80, puis convection entre l'air contenu dans la première baie 80 et le premier bâti 83 et notamment la première plaque 88 ;
- conduction entre les premiers modules 81 et 82 et le premier bâti 83 par les lames ressorts 83.1.

Cette chaleur est ensuite transmise par conduction au deuxième serpentin 86 qui la transmet par convection au flux d'eau glycolée 11 mis en circulation dans le circuit 10 par la pompe de circulation 12. Le flux d'eau glycolée 11 est refroidi lors de son passage dans le premier serpentin 24 par un échange par convection entre le premier serpentin 24 et le flux d'air 33 issu de l'évacuation d'air 30. L'eau glycolée 11 refroidie est ensuite retournée vers la baie avionique 80. Des échanges de chaleur identiques ont lieu entre les deuxièmes modules 181 et 182, la deuxième baie avionique 180 et le circuit fermé 10.

Des capteurs de température de l'eau glycolée 11 peuvent être ajoutés en divers points du circuit fermé 10 et être reliés à l'unité de commande 40 pour réguler le fonctionnement de la pompe de circulation 12 et/ou le fonctionnement du ventilateur 32.

En cas de défaillance de la pompe de circulation 12, l'échauffement de l'intérieur de la première baie avionique 80 est mesuré par le premier capteur de température 95 et détecté par la première unité d'alimentation et de communication 70 qui commande alors la mise en route du premier circulateur 93 voire du deuxième ventilateur 94. La deuxième baie 180 fonctionne de manière identique en cas de défaillance de la pompe de circulation 12.

En cas de défaillance de la ventilation de la cabine 31, l'unité de commande 40 met en route le premier ventilateur 32 pour assurer une circulation d'air autour du premier serpentin 24. Une telle situation ne peut se produire qu'au sol car la ventilation de la cabine 31 est généralement assurée par des prises d'air (RAM intake) extérieures lorsque l'aéronef 1 est en vol. La deuxième baie 180 fonctionne de manière identique en cas de défaillance de la ventilation de la cabine 31.

Bien entendu, l'invention ne se limite pas aux modes de réalisations décrits mais englobe toute variante entrant dans le champ de l'invention telle que définie par les revendications.

## Revendications

1. Dispositif de refroidissement (100) d'au moins un module électronique (81, 82) placé dans une baie avionique (80) d'un aéronef (1) comprenant une cabine ventilée (31), le dispositif de refroidissement (1) comprenant :
- un circuit fermé (10) de circulation d'un liquide caloporteur (11) ;
- des premiers moyens de circulation du liquide caloporteur (12) dans le circuit fermé (10
- un premier échangeur thermique (50) comprenant un circuit froid (51) qui est pourvu de premiers moyens de liaison (89, 90) au circuit fermé (10) de liquide caloporteur (11) et qui est thermiquement relié à une source chaude de la baie d'aéronef (80) ;
- un deuxième échangeur thermique (60) comprenant un circuit chaud (61) pourvu de deuxièmes moyens de liaison (20, 21) au circuit fermé (10) de liquide caloporteur (11) et un circuit froid (62) thermiquement relié à une évacuation d'air (30) de la cabine ventilée (31).

2. Dispositif de refroidissement (100) selon la revendication 1, dans lequel le premier échangeur thermique (50) comprend des premiers moyens de forçage d'un flux d'air (94) .

3. Dispositif de refroidissement (100) selon l'une quelconque des revendications précédentes, dans lequel le deuxième échangeur thermique (60) comprend des deuxièmes moyens de forçage d'un flux d'air (32).

4. Dispositif de refroidissement (100) selon l'une des revendications 2 ou 3, dans lequel les premiers moyens et/ou les deuxièmes moyens de forçage d'un flux d'air comprennent un ventilateur (32, 94).

5. Dispositif de refroidissement (100) selon l'une quelconque des revendications précédentes, dans lequel le premier échangeur thermique (50) comprend des deuxièmes moyens de circulation (93) du liquide caloporteur (11) dans le circuit fermé (10).

6. Dispositif de refroidissement (100) selon la revendication 3, comprenant des moyens de pilotage et d'alimentation (40) des premiers moyens de forçage d'un flux d'air (32).

7. Dispositif de refroidissement (100) selon l'une quelconque des revendications précédentes, dans lequel les premiers moyens de circulation (12) du liquide caloporteur (11) comprennent une turbine (12) dont le rotor (2) fait office d'induit en court-circuit.

8. Procédé de refroidissement d'un module électronique (81,82) d'une baie avionique (80) d'aéronef (1) comprenant une première étape de transférer de la chaleur depuis le module électronique (81, 82) vers un circuit fermé (10) de liquide caloporteur (11) par un premier échangeur thermique (201) comprenant un circuit froid qui est pourvu de premiers moyens de liaison au circuit fermé et une deuxième étape d'évacuer la chaleur du liquide caloporteur (11) vers un flux d'air prélevé sur une évacuation d'air d'une cabine ventilée (31) de l'aéronef (1) par un deuxième échangeur thermique (209) comprenant un circuit chaud (203) pourvu de deuxièmes moyens de liaison (203) au circuit fermé (10) de liquide caloporteur (11) et un circuit froid (62) thermiquement relié à l'évacuation d'air de la cabine ventilée (31).

9. Aéronef (1) comportant un dispositif de refroidissement (100) selon l'une quelconques des revendications 1 à 7.

## Patentansprüche

1. Kühlvorrichtung (100) zum Kühlen mindestens eines elektronischen Moduls (81, 82), das in einem Avionik-Rack (80) eines Luftfahrzeugs (1) platziert ist, das eine belüftete Kabine (31) umfasst, wobei die Kühlvorrichtung (1) umfasst:
- einen geschlossenen Kreislauf zur Zirkulation einer Wärmeübertragungsflüssigkeit (11);
- erste Zirkulationsmittel zur Zirkulation der Wärmeübertragungsflüssigkeit (12) in dem geschlossenen Kreislauf (10),
- einen ersten Wärmetauscher (50), der einen Kaltkreislauf (51) umfasst, der mit ersten Verbindungsmitteln (89, 90) zur Verbindung mit dem geschlossenen Kreislauf (10) für die Wärmeübertragungsflüssigkeit (11) versehen und thermisch mit einer heißen Quelle des Luftfahrzeug-Racks (80) verbunden ist;
- einen zweiten Wärmetauscher (60), der einen Heißkreislauf (61) umfasst, der mit zweiten Verbindungsmitteln (20, 21) zur Verbindung mit dem geschlossenen Kreislauf (10) für die Wärmeübertragungsflüssigkeit (11) versehen ist, sowie einen Kaltkreislauf (62), der thermisch mit einer Luftabführung (30) zur Abführung von Luft aus der belüfteten Kabine (31) verbunden ist.

2. Kühlvorrichtung (100) nach Anspruch 1, bei der der erste Wärmetauscher (50) erste Mittel zum Erzwingen eines Luftstroms (94) umfasst.

3. Kühlvorrichtung (100) nach einem der vorhergehenden Ansprüche, bei der der zweite Wärmetauscher (60) zweite Mittel zum Erzwingen eines Luftstroms (32) umfasst.

4. Kühlvorrichtung (100) nach einem der Ansprüche 2 oder 3, bei der die ersten Mittel und/oder die zweiten Mittel zum Erzwingen eines Luftstroms einen Ventilator (32, 94) umfassen.

5. Kühlvorrichtung (100) nach einem der vorhergehenden Ansprüche, bei der der erste Wärmetauscher (50) zweite Zirkulationsmittel (93) zur Zirkulation der Wärmeübertragungsflüssigkeit (11) in dem geschlossenen Kreislauf (10) umfasst.

6. Kühlvorrichtung (100) nach Anspruch 3, umfassend Steuer- und Speisungsmittel (40) zum Steuern und Speisen der ersten Mittel zum Erzwingen eines Luftstroms (32).

7. Kühlvorrichtung (100) nach einem der vorhergehenden Ansprüche, bei der die ersten Zirkulationsmittel (12) zur Zirkulation der Wärmeübertragungsflüssigkeit (11) eine Turbine (12) umfassen, deren Rotor (2) als Kurzschlussläufer dient.

8. Verfahren zum Kühlen eines elektronischen Moduls (81, 82) eines Avionik-Racks (80) eines Luftfahrzeugs (1), umfassend einen ersten Schritt des Übertragens von Wärme von dem elektronischen Modul (81, 82) zu einem geschlossenen Kreislauf (10) für die Wärmeübertragungsflüssigkeit (11) durch einen ersten Wärmetauscher (201), der einen Kaltkreislauf umfasst, der mit ersten Verbindungsmitteln zur Verbindung mit dem geschlossenen Kreislauf versehen ist, und einen zweiten Schritt des Abführens von Wärme von der Wärmeübertragungsflüssigkeit (11) zu einem Luftstrom, der aus einer Luftabführung einer belüfteten Kabine (31) des Luftfahrzeugs (1) entnommen wird, durch einen zweiten Wärmetauscher (209), der einen Heißkreislauf (203) umfasst, der mit zweiten Verbindungsmitteln (203) zur Verbindung mit dem geschlossenen Kreislauf für die Wärmeübertragungsflüssigkeit versehen ist, sowie einen Kaltkreislauf, der thermisch mit der Luftabführung zur Abführung von Luft aus der belüfteten Kabine (31) verbunden ist.

9. Luftfahrzeug (1), umfassend eine Kühlvorrichtung (100) nach einem der Ansprüche 1 bis 7.

## Claims

1. A device (100) for cooling at least one electronic module (81, 82) placed in an avionics rack (80) of an aircraft (1) comprising a ventilated cabin (31), the cooling device (1) comprising:
- a closed circuit (10) for circulating a heat-transfer fluid (11);
- first means for circulating the heat-transfer fluid (12) in the closed circuit (10) ;
- a first heat exchanger (50) comprising a cold circuit (51) which is provided with first means (89, 90) for connecting to the closed circuit (10) for circulating a heat-transfer fluid (11) and which is thermally connected to a hot source of the aircraft rack (80);
- a second heat exchanger (60) comprising a hot circuit (61) provided with second means (20, 21) for connecting to the closed circuit (10) for circulating a heat-transfer fluid (11) and a cold circuit (62) thermally connected to an air exhaust (30) of the ventilated cabin (31) .

2. A cooling device (100) according to claim 1, wherein the first heat exchanger (50) comprises first means for forcing an air flow (94).

3. A cooling device (100) according to any one of the preceding claims, wherein the second heat exchanger (60) comprises second means for forcing an air flow (32).

4. A cooling device (100) according to one of claims 2 or 3, wherein the first means and/or second means for forcing an air flow comprise a fan (32, 94).

5. A cooling device (100) according to any one of the preceding claims, wherein the first heat exchanger (50) comprises second means (93) for circulating the heat-transfer fluid (11) in the closed circuit (10).

6. A cooling device (100) according to claim 3, comprising means for controlling and supplying (40) the first means for forcing an air flow (32).

7. A cooling device (100) according to any one of the preceding claims, wherein the first means for circulating (12) the heat-transfer fluid (11) comprise a turbine (12) the rotor (2) of which acts as a shortcircuited armature.

8. A method for cooling an electronic module (81, 82) of an aircraft (1) avionics rack (80) comprising a first step of transferring heat from the electronic module (81, 82) to a closed circuit (10) for circulating a heat-transfer fluid (11) by a first heat exchanger (201) comprising a cold circuit which is provided with first means for connecting to the closed circuit and a second step of removing heat from the heat-transfer fluid (11) to an air flow extracted through an air exhaust of a ventilated cabin (31) of the aircraft (1) by a a second heat exchanger (209) comprising a hot circuit (203) provided with second means for connecting to the closed circuit for circulating a heat-transfer fluid (11) and a cold circuit (62) thermally connected to the air exhaust of the ventilated cabin (31).

9. An aircraft (1) comprising a cooling device (100) according to any one of claims 1 to 7,
